# EUROPEAN PATENT APPLICATION

(11) **EP 4 156 310 A1**
(43) Date of publication of application: **29.03.2023**
(21) Application number: 21199621.0
(22) Date of filing: 28.09.2021
(51) Int. Cl.: H01L 31/05, H01L 31/0224

(54) **SOLAR CELL MODULE**

(71) Applicant: Meyer Burger (Switzerland) AG, 3645 Gwatt/Thun (CH)
(72) Inventor: GRISCHKE, Rainer, 1786 Sugiez (CH); ERB-SCHWAB, Tanja, 3752 Wimmis (CH)
(74) Representative: Vissel, Horst Friedrich Georg

(57) **Abstract**

Examples provide a solar cell module (2000) comprising a first solar cell (2111) including solar cell contacts (2121) having a first polarity and solar cell contacts (2122) having a second polarity, a first plurality of parallel connecting wires (2131) having a contacting portion (2151) electrically contacting the solar cell contacts (2121) having the first polarity and a bended portion (2152) being arranged parallel to the contacting portion (2151), a second plurality of parallel connecting wires (2132) electrically contacting the solar cell contacts (2122) having the second polarity, an interconnector (2140) crossing the bended portions (2152) and electrically contacting the bended portions (2152), wherein the interconnector (2140) is arranged at a side of the bended portions (2152) facing the contact portions (2151), wherein a buffer strip (2700) is arranged between the bended portions (2152) and the contacting portions (2151), wherein the buffer strip (2700) is arranged between the second plurality of connecting wires (2132) and the interconnector (2140), wherein the buffer strip (2700) is configured for reducing a pressure exerted by the interconnector (2700) on the connecting wires (2132) of the second plurality of connecting wires (2132) during formation of the solar cell module (2000).

## Description

The disclosure relates to a solar cell module. A solar cell module may also be called a photovoltaic module.

WO 2015/001413 A1 discloses a solar cell module, sometimes also called photovoltaic module, comprising several solar cell strings, wherein each solar cell string comprises several solar cells connected in series. The solar cells are arranged between a front-side encapsulation layer and a back-side encapsulation layer.

Further, WO 2011/011855 A1 proposes a method for connecting several rear contact solar cells, in particular interdigitated back contact (IBC) solar cells. In particular, solar cell strings may be formed by electrically connecting several solar cells in series using a plurality of parallel connecting wires.

According to WO 2019/191689 A1, solar cells may have wire metallization thereon stringing the solar cells. Busbars and/or interconnectors are included at the ends of the wire metallization. The busbars or interconnectors are folded over a footprint of the solar cells. An insulator feature can be included to isolate the folded portion of the wire metallization from another wire metallization on the solar cells. Said wire-based metallization may enable fabrication of busbars or interconnectors that are folded in behind cells to reduce overall solar cell module size and thus increase solar cell module efficiency.

It has been found that it is challenging to manufacture solar cell modules comprising busbars folded in behind the solar cells without damaging the solar cells.

Thus, there may be a need for a solar cell module being less prone to failure during manufacture.

Said need has been addressed with the subject-matter of the independent claim. Advantageous embodiments are described in the dependent claims.

Examples disclose a solar cell module comprising a first solar cell including solar cell contacts having a first polarity and solar cell contacts having a second polarity, a first plurality of parallel connecting wires having a contacting portion electrically contacting the solar cell contacts having the first polarity and a bended portion being arranged parallel to the contacting portion, a second plurality of parallel connecting wires electrically contacting the solar cell contacts having the second polarity, an interconnector crossing the bended portions and electrically contacting the bended portions, wherein a buffer strip is arranged between the bended portions and the contacting portions, wherein the buffer strip is arranged between the second plurality of connecting wires and the interconnector, wherein the buffer strip is configured for reducing a pressure exerted by the interconnector on the connecting wires of the second plurality of connecting wires during formation of the solar cell module.

Examples disclose a solar cell module comprising a first solar cell including solar cell contacts having a first polarity and solar cell contacts having a second polarity, a first plurality of parallel connecting wires having a contacting portion electrically contacting the solar cell contacts having the first polarity and a bended portion being arranged parallel to the contacting portion, a second plurality of parallel connecting wires electrically contacting the solar cell contacts having the second polarity, an interconnector crossing the bended portions and electrically contacting the bended portions, wherein the interconnector is arranged at a side of the bended portions facing the contact portions, wherein a buffer strip is arranged between the bended portions and the contacting portions, wherein the buffer strip is arranged between the second plurality of connecting wires and the interconnector, wherein a first Young's modulus of the buffer strip is lower than a second Young's modulus of the connecting wires of the second plurality of connecting wires.

Examples disclose a solar cell module comprising a first solar cell including solar cell contacts having a first polarity and solar cell contacts having a second polarity, a first plurality of parallel connecting wires having a contacting portion electrically contacting the solar cell contacts having the first polarity and a bended portion being arranged parallel to the contacting portion, a second plurality of parallel connecting wires electrically contacting the solar cell contacts having the second polarity, an interconnector crossing the bended portions and electrically contacting the bended portions, wherein the interconnector is arranged at a side of the bended portions facing the contact portions. The solar cell module further comprises a first solar cell unit and a second solar cell unit, wherein the first solar cell unit and the second solar cell unit are electrically connected in parallel, wherein the first solar cell unit comprises a solar cell subunit, wherein the second solar cell unit comprises a solar cell subunit, wherein the first solar cell is part of the first solar cell subunit.

Examples of the proposed solar cell module are described with respect to the drawing in which:
- Fig. 1: shows a solar cell string;
- Fig. 2: shows two solar cell strings connected in series;
- Fig. 3: shows a portion of a solar cell module;
- Fig. 4: shows a portion of a solar cell module;
- Fig. 5: shows a portion of a solar cell module;
- Fig. 6: illustrates an electrical circuit of a solar cell module;
- Fig. 7: shows a portion of the solar cell module of Fig. 6; and
- Fig. 8: shows a portion of a solar cell module.

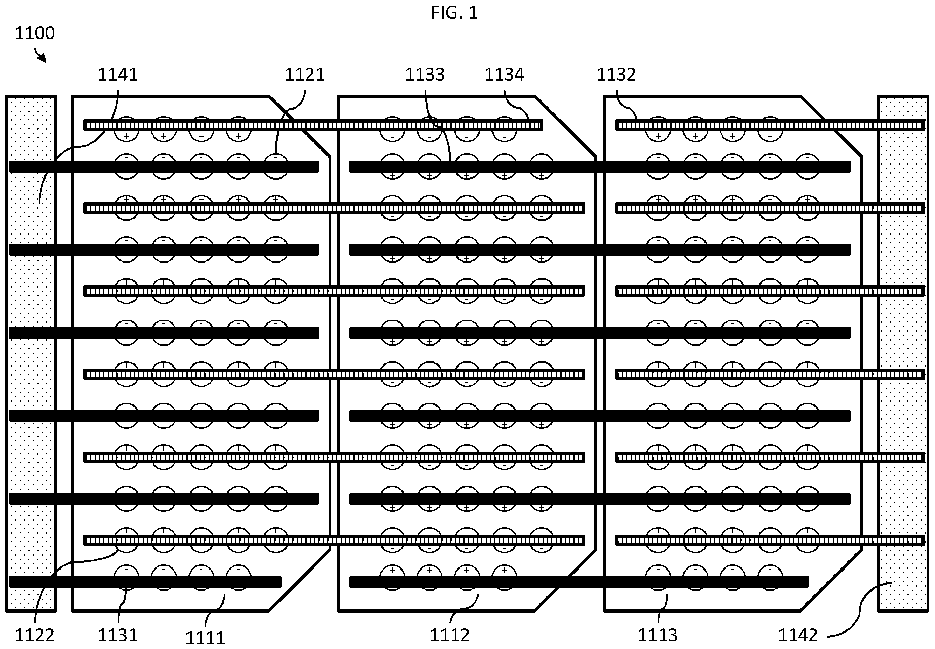

Fig. 1 shows a solar cell string 1100. The solar cell string 1100 comprises three solar cells 1111, 1112, 1113 arranged in a row. Generally, a solar cell string may also comprise fewer or more solar cells arranged in a row. The first solar cell 1111 comprises solar cell contacts 1121 having a first polarity and solar cell contacts 1122 having a second polarity. In the example, the first polarity is minus (-) and the second polarity is plus (+). The solar cell contacts 1121 having the first polarity and the solar cell contacts 1122 having the second polarity may be both provided on one side, typically the backside, of the first solar cell 1111. A first plurality of parallel connecting wires 1131 electrically contacts the solar cell contacts 1121 having the first polarity and a second plurality of parallel connecting wires electrically contacts the solar cell contacts 1122 having the second polarity.

An interconnector 1141 crosses and electrically contacts the first plurality of parallel connecting wires 1131. The second plurality of parallel connecting wires electrically contacts solar cell contacts having the first polarity of the second solar cell 1112. Thus, the second plurality of parallel connecting wires electrically connects the first solar cell 1111 and the second solar cell 1112 in series. Likewise, a further plurality of parallel connecting wires 1132, 1133 may be used for electrically connecting the second solar cell 1112 in series with the third solar cell 1113 and for electrically connecting the third solar cell 1113 to the interconnector 1142, respectively.

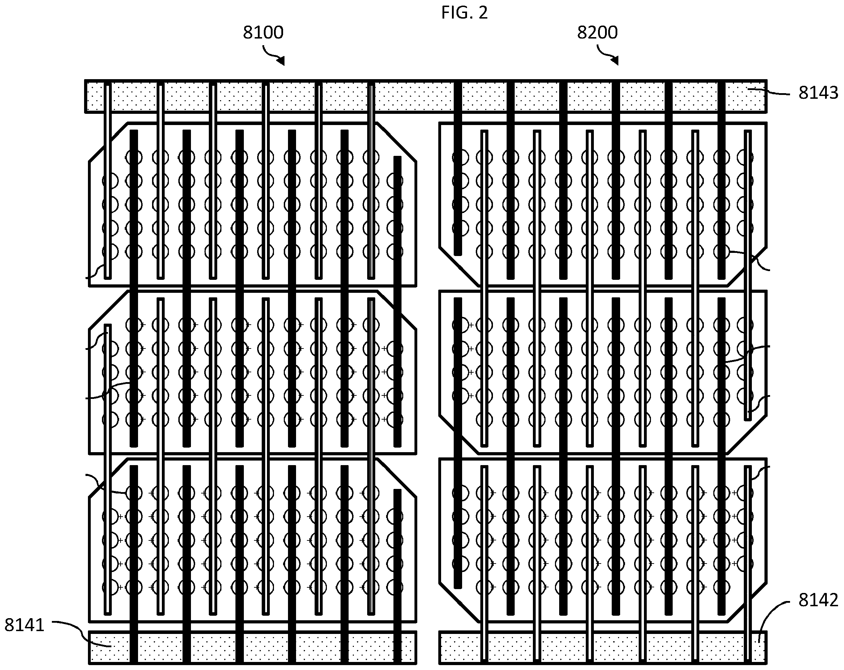

Fig. 2 illustrates a first solar cell string 8100 and a second solar cell string 8200. The parallel connecting wires of the first solar cell string 8100 and the second solar cell string 8200 may be electrically connected with interconnectors 8141, 8142, 8143. The interconnector 8143 in addition to electrically contacting parallel connecting wires of the first solar cell string 8100 also electrically contacts parallel connecting wires of the second solar cell string 8200. Thus, the interconnector 8143 electrically connects the solar cell strings 8100, 8200 in series. Similarly, an interconnector could also connect to solar cell strings in parallel. An interconnector connecting only the parallel connecting wires of a single solar cell string may also be called a busbar.

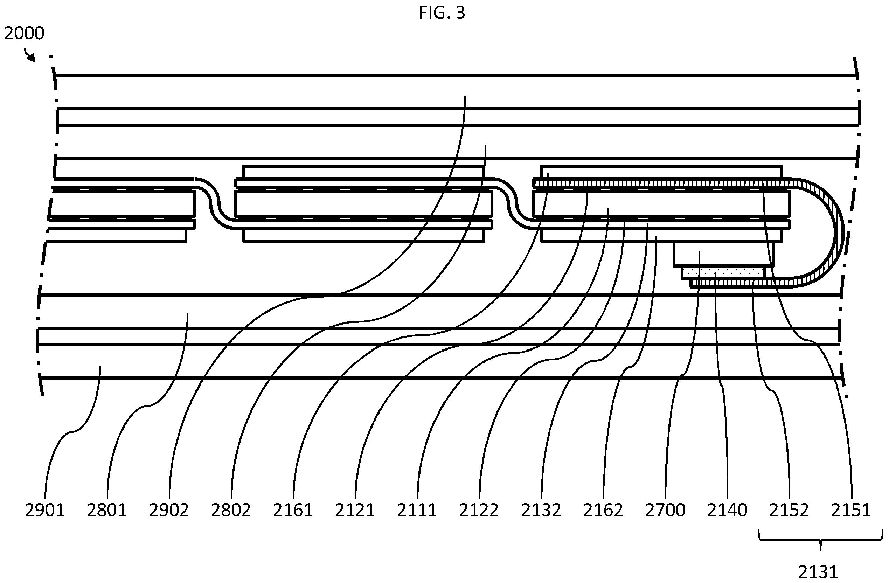

Fig. 3 shows a solar cell module 2000. The solar cell module 2000 comprises a first solar cell 2111 including solar cell contacts 2121 having a first polarity and solar cell contacts 2122 having a second polarity. In some examples, the first polarity may be minus (-) and the second polarity may be plus (+). In other examples, the first polarity may be plus (+) and the second polarity may be minus (-).

A first plurality of parallel connecting wires 2131 having a contacting portion 2151 electrically contacts the solar cell contacts 2121 having the first polarity. The connecting wires 2131 further have bended portions 2152 arranged parallel to the contacting portions 2151. A second plurality of parallel connecting wires 2132 electrically contacts the solar cell contacts 2122 having the second polarity.

An interconnector 2140 crosses the bended portions 2152 and electrically contacts the bended portions 2152. The interconnector 2140 is arranged at a side of the bended portions 2152 facing the contact portions 2151. The provision of connecting wires 2131 having contact portions 2151 and bended portions 2152 may allow for providing the interconnector 2140 below (or above) the first solar cell 2111 instead of providing an interconnector 2140 laterally of the first solar cell 2111. Thus, the relative surface of the solar module 2000 used for generating current may be enlarged. This may allow for increasing the efficiency of a solar cell module 2000 having given lateral dimensions.

A buffer strip 2700 is arranged between the bended portions 2152 and the contacting portions 2151.The buffer strip 2700 is configured for reducing a pressure exerted by the interconnector 2140 on the connecting wires 2132 of the second plurality of connecting wires 2132 during formation of the solar cell module 2000. This may allow for reducing the risk of damages during manufacture of the solar cell module 2000.

A first Young's modulus of the buffer strip 2700 is lower than a second Young's modulus of the connecting wires 2132 of the second plurality of connecting wires 2132. This may allow for reducing the risk of damages during manufacture of the solar cell module 2000.

The first Young's modulus may be less than 80 percent, in particular less than 50 percent, more particularly less than 30 percent, of the second Young's modulus.

As shown in Fig. 3, the first solar cell 2111 may be arranged between the contact portions 2151 and the bending portions 2152 of the connecting wires 2131. This may allow for a larger radius of the connecting wires 2131 between the bending portions 2152 and the contact portions 2151 which may avoid kinks in the connecting wires 2131.

For manufacturing the solar cell module 2000, the pluralities of parallel connecting wires 2131, 2132 and foil segments 2161, 2162 may be provided. The foil segments 2161, 2162 may at least temporarily fix the relative position of the connecting wires 2131, 2132. Afterwards, the foil segments 2161, 2162 may be arranged on the solar cell 2111 such that the connecting wires 2131, 2132 are arranged between the foil segments 2161, 2162 and the solar cell 2111. The foil segments 2161, 2162 may comprise an adhesive for at least temporarily fixing the foil segments 2161, 2162 to the solar cell 2111. The connecting wires 2132 of the second plurality of connecting wires 2132 are configured for connecting the first solar cell 2111 and a neighbouring solar cell in series. Solar cell contacts of the same polarity are provided on the same side of the solar cell 2111 and the neighbouring solar cell.

A buffer strip 2700 is provided on a side of the foil segment 2162 opposite to the solar cell 2111. An interconnector 2140 is arranged on a side of the buffer strip 2700 opposite to the solar cell 2111.

In some examples (not shown), a dedicated electrical insulating layer may be provided between the foil segment 2162 and the buffer strip 2700 and/or between the buffer strip 2700 and the interconnector 2140. In other examples, the foil segment 2162 and/or the buffer strip 2700 may serve for electrically insulating the interconnector 2140 from the connecting wires 2132 of the second plurality of connecting wires 2132. It is also conceivable that the insulating layer is provided as a coating of the interconnector 2140.

The connecting wires 2131 of the first plurality of connecting wires 2131 may be bent around the edge of the solar cell 2111 such that the interconnector 2140 is arranged between the bended portions 2152 and the contact portions 2151 of the connecting wires 2131.

The formed structure may be arranged between encapsulating layers 2801, 2802, a backsheet 2901, and a frontsheet 2902. Pressure and heat may be applied to the backsheet 2901, the encapsulating layer 2801, the structure, the encapsulating layer 2802 and the frontsheet to form a laminate. Due to the pressure and heat, the first encapsulation material of the first encapsulating layer 2801 and/or the second encapsulation material of the second encapsulation layer 2802 may become soft and flow into cavities of the structure. Likewise, solder of the interconnector 2140 and/or the connecting wires 2131, 2132 may melt to form electrical solder contacts between the interconnector 2140 and the bended portions 2152, between the contact portions 2151 and the solar cell contacts 2121, as well as between the connecting wires 2132 and the solar cell contacts 2122.

Due to the buffer strip 2700, most of the pressure applied by the comparably rigid interconnector 2140 is not transferred to the connecting wires 2132 of the plurality of connecting wires 2132 but distributed on a larger area. Thus, the connecting wires 2132 of the second plurality of connecting wires 2132 induce less pressure on the solar cell 2111. This may substantially reduce the formation of cracks in the solar cell 2111 during manufacture of the solar cell module 2000.

The connecting wires may have a diameter greater than 400 µm, in particular greater than 250 µm, and/or less than 400 µm, in particular less than 250 µm. The foil segments may have a thickness greater than 50 and/or less than 100 µm. The interconnector may have a width greater than 3 mm and/or less than 12 mm, in particular less than 9 mm. The thickness of the interconnector may be greater than 50 µm, in particular greater than 100 µm, and/or less than 300 µm, in particular less than 200. The buffer strip may have a thickness greater than 200 µm, in particular greater than 300 µm, and/or less than 600 µm, in particular less than 400 µm.

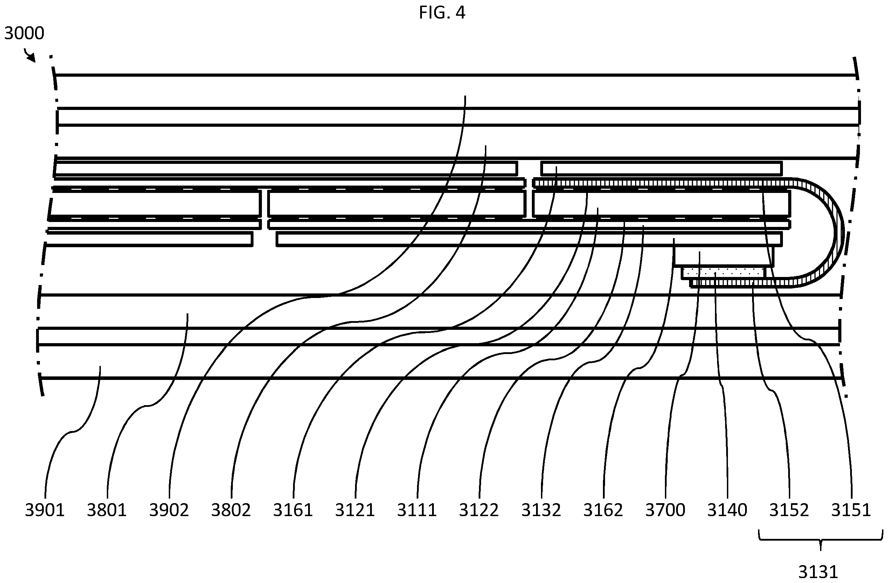

Fig. 4 shows a portion of a solar cell module 3000 also comprising a solar cell 3111 with solar cell contacts 3121 having a first polarity and solar cell contacts 3122 having a second polarity. The solar cell module 3000 likewise included a first plurality of connecting wires 3131 with contacting portions 3151 for contacting the solar cell contacts 3121 having the first polarity and bended portions 3152 for connecting the interconnector 3140. A second plurality of connecting wires 3132 is provided contacting the solar cell contacts 3122 having the second polarity. The first plurality of connecting wires 3131 and the second plurality of connecting wires 3132 may be preliminary attached to the solar cell 3111 using foil segments 3161, 3162.

An interconnector 3140 is arranged between the contacting portions 3151 and the bended portions 3152. A buffer strip 3700 is arranged between the second plurality of connecting wires 3132 and the interconnector 3140.

The solar cell module 3000 further includes encapsulation layers 3801, 3802, a backsheet 3901 and a frontsheet 3902.

In contrast to the solar cell module 2000 shown in Fig. 3, the solar cell contacts 3121 having the first polarity of the solar cell 3111 and the solar cell contacts having the first polarity of the neighbouring solar cell are arranged on opposite sides. Thus, the solar cell 3111 and the neighbouring solar cell may be arranged on the same side of the second plurality of connecting wires 3132 which connects the first solar cell 3111 and the neighbouring solar cell in series. Thus, the first solar cell 3111 and the neighbouring solar cell may be arranged closer together. This may further improve the efficiency of the solar cell module 3000.

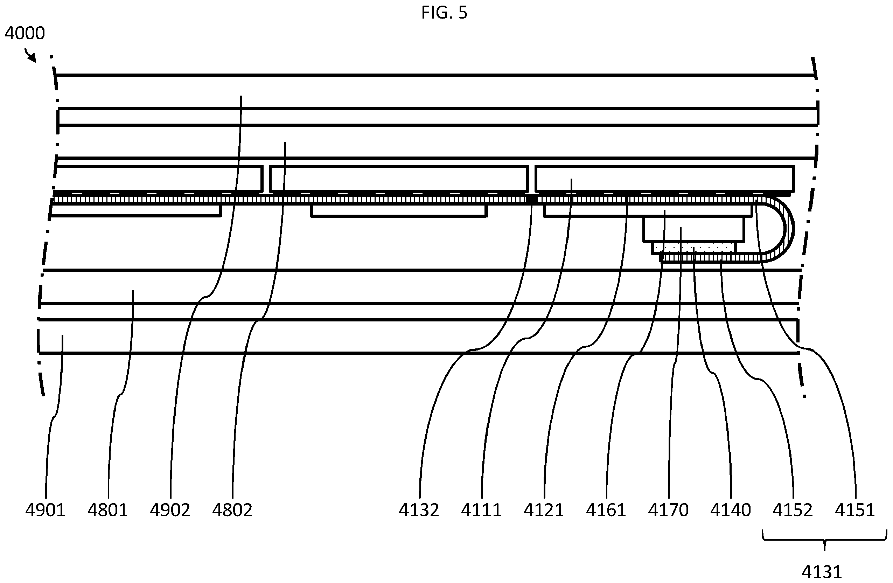

Fig. 5 shows a further solar cell module 4000. Like the solar cells 1111, 1112, 1113 shown in Fig. 1. The solar cell contacts 4121 having the first polarity and the solar cell contacts (not visible) having the second polarity are provided on the same side of the solar cell 4111.

A first plurality of connecting wires 4131 with contacting portions 4151 electrically contacts the solar cell contacts 4121 having the first polarity. A second plurality of connecting wires 4132 behind the first plurality of connecting wires 4131 and only visible between the solar cell 4111 and the neighbouring solar cell electrically contacts the solar cell contacts having the second polarity. The first plurality of connecting wires 4131 and the second plurality of connecting wires 4132 may be preliminary attached to the solar cell 4111 using foil segment 4161.

Between the contacting portions 4151 and the bended portions 4152 of the connecting wires 4131 of the first plurality of connecting wires 4131, an interconnector 4140 is arranged. Further, a buffer strip 4170 is provided between the second plurality of connecting wires and the interconnector 4140.

In addition, the solar cell module 4000 comprises encapsulation layers 4801, 4802, a backsheet 4901 and a frontsheet 4902.

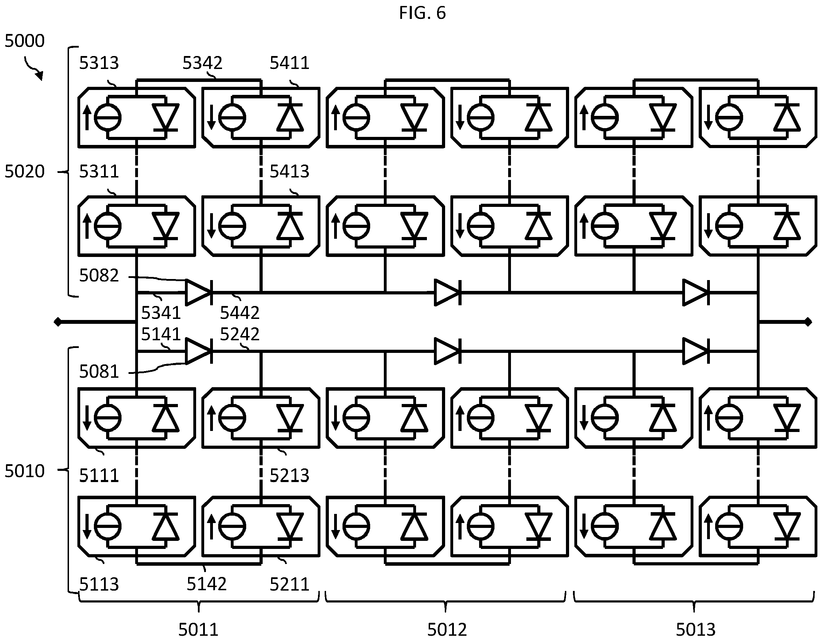

Fig. 6 schematically illustrates an electrical circuit of a solar cell module 5000 and an arrangement of solar cells of the solar cell module 5000.

The solar cell module 5000 comprises a first solar cell unit 5010 and a corresponding second solar cell unit 5020. The first solar cell unit 5010 and the second solar cell unit 5020 are electrically connected in parallel. The first solar cell unit 5010 comprises three similar solar cell subunits 5011, 5012, 5013 connected in series. Generally, the first solar cell unit 5010 may also comprise a fewer or more subunits connected in series.

The first solar cell subunit comprises a first solar cell string including the solar cells 5111, ..., 5113 and a second solar cell string including the solar cells 5213, ..., 5211. Each solar cell string may comprise two or more solar cells. The solar cells of the solar cell strings may be electrically connected in series with connecting wires similarly to the examples shown in Fig. 1 to 4.

The first solar cell string may be electrically connected in series with the second solar cell string using an interconnector 5142. In particular, the first solar cell string and the second solar cell string may share the same interconnector 5142. The Interconnector 5142 may be arranged behind the solar cells 5113, 5211 similar to the interconnectors 2140, 3140, 4140 shown in Fig. 3 to 4.¨A first bridging element 5081 is electrically connected in parallel to the solar cell subunit 5011. Similarly, a second bridging element 5082 is electrically connected in parallel to a solar cell subunit of the second solar cell unit 5020. Further bridging elements may be provided for the solar cell subunits of the first solar cell unit 5010 and the second solar cell unit 5020. The bridging elements shown in Fig. 1 are diodes. However, the diodes may be replaced with different bridging element, e.g. active switches.

The bridging element 5081 is electrically connected to interconnectors (5141, 5242) of solar cells 5111, 5213 and the bridging element 5082 is electrically connected to interconnectors (5341, 5442) of solar cells 5311, 5413. Providing separate bridging elements for the solar cell subunits of the first solar cell unit and the second solar cell unit may further increase the efficiency of the solar cell module compared to known solar cell module, in which two solar cell subunits electrically connected in parallel share one or more common bridging elements.

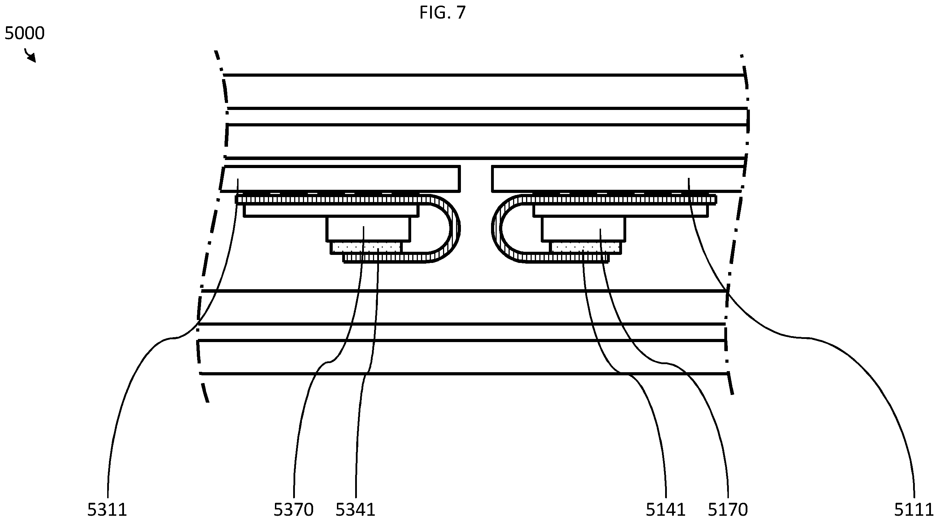

As shown in Fig. 7, the interconnectors 5341, 5141 of the solar cells 5311, 5111 are provided behind the solar cells 5311, 5111. Thus, the advantages of separate bridging elements are not counteracted by additional place between the solar cell 5111, 53111 required for the additional connectors necessary for the separate bridging elements 5081, 5082. Instead, the distance between the solar cells of a solar cell string may (e.g., the distance between the three solar cells 5111, ..., 5113) may correspond to the distance between the neighbouring solar cells of two different solar cell unit (e.g., the distance between the solar cells 5111 and 5311). This may in addition improve the esthetical appearance of the solar cell module 5000. In some examples of the solar cell module 5000 shown in Fig. 6, 7 and 8, the buffer strips 5170, 5370 may also be omitted.

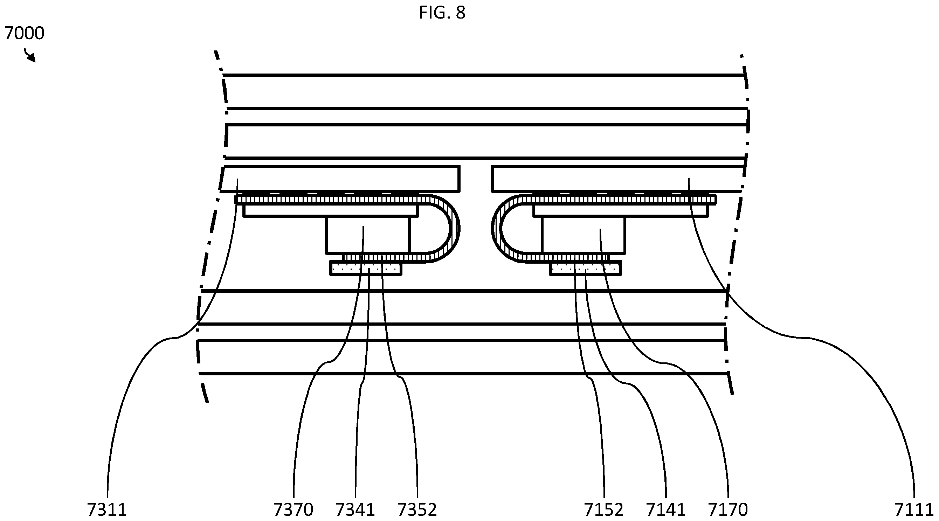

Fig. 8 shows a part of a solar cell module 7000 similar to the solar cell module 5000 and comprising solar cells 7111, 7311. In contrast to the solar cell module 5000, the bending portions 7152, 7352 of the connecting wires are provided between the interconnectors 7141, 7341 and the buffer strips 7170, 7370. This may allow for mechanically connecting the bending portions 7152, 7352 of the connecting wires to the interconnectors 7141, 7341 before bending the connecting wires. Thus, heat which may be required for connecting the bending portions 7152, 7352 to the interconnectors 7141, 7341, for example heat used for soldering, may be kept away from the buffer strips 7170, 7370.

Summarizing at least the following examples are disclosed:
EXAMPLE 1. Solar cell module (2000, 3000, 4000, 5000, 7000) comprising
   a first solar cell (2111;3111, 4111, 5111, 7111) including solar cell contacts (2121; 3121, 4121) having a first polarity and solar cell contacts (2122, 3122) having a second polarity,
   a first plurality of parallel connecting wires (2131, 3131, 4131) having a contacting portion (2151, 3151, 4151) electrically contacting the solar cell contacts (2121, 3121, 4121) having the first polarity and a bended portion (2152, 3152, 4152, 7152) being arranged parallel to the contacting portion (2151, 3151, 4151),
   a second plurality of parallel connecting wires (2132, 3132, 4132) electrically contacting the solar cell contacts (2122, 3122, 4122) having the second polarity,
   an interconnector (2140, 3140, 4140, 5141, 7141) crossing the bended portions (2152, 3152, 4152, 7152) and electrically contacting the bended portions (2152, 3152, 4152, 7152),
   wherein a buffer strip (2700, 3700, 4170, 5170, 7170) is arranged between the bended portions (2152, 3152, 4152, 7152) and the contacting portions (2151, 3151, 4151),
   wherein the buffer strip (2700, 3700, 4170, 5170, 7170) is arranged between the second plurality of connecting wires (2132, 3132, 4132) and the interconnector (2140, 3140, 4140, 5141, 7141),
   wherein the buffer strip (2700, 3700, 4170, 5170, 7170) is configured for reducing a pressure exerted by the interconnector (2140, 3140, 4140, 5141, 7141) on the connecting wires (2132, 3132, 4132) of the second plurality of connecting wires (2132, 3132, 4132) during formation of the solar cell module (2000, 3000, 4000, 5000, 7000).
EXAMPLE 2. Solar cell module (2000, 3000, 4000, 7000) according to EXAMPLE 1,
   wherein a first Young's modulus of the buffer strip (2700, 3700, 4170, 5170, 7170) is lower than a second Young's modulus of the connecting wires (2132) of the second plurality of connecting wires (2132).
EXAMPLE 3. Solar cell module (2000) according to EXAMPLE 1 or 2,
   wherein the first Young's modulus is less than 80 percent, in particular less than 50 percent, more particularly less than 30 percent, of the second Young's modulus.
EXAMPLE 4. Solar cell module (2000) according to any one of EXAMPLEs 1 to 3,
   wherein the first solar cell (2111) is arranged between the contact portions (2151) and the bending portions (2152).
EXAMPLE 5. Solar cell module (4000) according to any one of EXAMPLEs 1 to 3,
   wherein the contact portions (4151) are arranged between the first solar cell (4111) and the bending portions (4152).
EXAMPLE 6. Solar cell module (2000) according to any one of the preceding EXAMPLEs, further comprising
   an insulating layer for electrically insulating the interconnector (2140) from the connecting wires (2132) of the second plurality of connecting wires (2132).
EXAMPLE 7. Solar cell module (2000) according to EXAMPLE 6,
   wherein the insulating layer (2162) is arranged between the buffer layer (2700) and the second plurality of connecting wires (2132).
EXAMPLE 8. Solar cell module (2000) according to EXAMPLE 6 or 7,
   wherein the insulating layer is arranged between the buffer layer (2700) and the interconnector (2140).
EXAMPLE 9. Solar cell module (2000) according to any one of EXAMPLEs 6 to 8,
   wherein the insulating layer comprises a coating of the interconnector (2140).
EXAMPLE 10. Solar cell module (2000, 3000, 4000) according to any one of the preceding EXAMPLEs,
   wherein the interconnector (2140, 3140, 4140) is arranged at a side of the bended portions (2152, 3152, 4152) facing the contact portions (2151, 3151).
EXAMPLE 11. Solar cell module (7000) according to any one of EXAMPLEs 1 to 9,
   wherein the interconnector (7141) is arranged at a side of the bended portions (7152) opposite to the contact portions.
EXAMPLE 12. Solar cell module (2000) according to any one of the preceding EXAMPLEs, further comprising
   a first encapsulation layer (2801) and a second encapsulation layer (2802), wherein the first encapsulation layer (2801) is made of a first encapsulation material, and
   wherein the buffer strip (2700) is made of the first encapsulation material.
EXAMPLE 13. Solar cell module (5000) according to any one of the preceding EXAMPLEs, comprising
   a first solar cell unit (5010) and a second solar cell unit (5020),
   wherein the first solar cell unit (5010) and the second solar cell unit (5020) are electrically connected in parallel,
   wherein the first solar cell unit (5010) comprises a solar cell subunit (5011),
   wherein the second solar cell unit (5020) comprises a solar cell subunit,
   wherein the first solar cell (5111) is part of the first solar cell subunit (5011).
EXAMPLE 14. Solar cell module (4000, 5000) according to any one of the preceding EXAMPLEs,
   wherein the first solar cell is an interdigitated back contact (IBC) solar cell.
EXAMPLE 15. Solar cell module (5000) according to any one of the preceding EXAMPLEs,
   wherein a distance between solar cells of the solar cell module (5000) arranged in a row is essentially equal for solar cells arranged in the row.
EXAMPLE 16. Solar cell module (5000) according to any one of the preceding EXAMPLEs,
   wherein a distance between solar cells of the solar cell module (5000) arranged in a column is essentially equal for solar cells arranged in the column.
EXAMPLE 17. Solar cell module (5000) according to any one of the EXAMPLEs 13 to 16,
   wherein at least the first solar cell unit (5010) comprises a first bridging element (5081) electrically connected in parallel to the solar cell subunit (5011).
EXAMPLE 18. Solar cell module (5000) according to EXAMPLE 17,
   wherein the first bridging element (5081) is electrically connected to the interconnector (2140).
EXAMPLE 19. Solar cell module (5000) according to EXAMPLE 18,
   wherein the first bridging element (5081) and the interconnector (2140) are provided on a same side of the first solar cell (5151).
EXAMPLE 20. Solar cell module (5000) according to any one of EXAMPLEs 13 to 19,
   wherein the first solar cell unit (5010) and the second solar cell unit (5020) are symmetrical, in particular mirror symmetrical.
EXAMPLE 21. Solar cell module (5000) according to any one of EXAMPLEs 13 to 20,
   wherein the first solar cell subunit (5011) comprises a first string of one or more solar cells (5111, ..., 5113) and a second string of one or more solar cells (5211, ..., 5213),
   wherein the solar cell(s) (5111, ..., 5113) of the first string are arranged in a first column and the solar cell(s) (5211, ..., 5213) of the second string are arranged in a second column,
   wherein the interconnector (5142) electrically connects the first string and the second string in series.
EXAMPLE 22. Solar cell module (5000) according to any one of EXAMPLEs 13 to 20,
   wherein the first solar cell unit (5001) comprises a second solar cell subunit (5012),
   wherein the interconnector (5242) electrically connects the first solar cell subunit (5011) and the second solar cell subunit (5012) in series.

## Claims

1. Solar cell module (2000, 3000, 4000, 5000, 7000) comprising
a first solar cell (2111;3111, 4111, 5111, 7111) including solar cell contacts (2121; 3121, 4121) having a first polarity and solar cell contacts (2122, 3122) having a second polarity,
a first plurality of parallel connecting wires (2131, 3131, 4131) having a contacting portion (2151, 3151, 4151) electrically contacting the solar cell contacts (2121, 3121, 4121) having the first polarity and a bended portion (2152, 3152, 4152, 7152) being arranged parallel to the contacting portion (2151, 3151, 4151),
a second plurality of parallel connecting wires (2132, 3132, 4132) electrically contacting the solar cell contacts (2122, 3122, 4122) having the second polarity,
an interconnector (2140, 3140, 4140, 5141, 7141) crossing the bended portions (2152, 3152, 4152, 7152) and electrically contacting the bended portions (2152, 3152, 4152, 7152),
wherein a buffer strip (2700, 3700, 4170, 5170, 7170) is arranged between the bended portions (2152, 3152, 4152, 7152) and the contacting portions (2151, 3151, 4151),
wherein the buffer strip (2700, 3700, 4170, 5170, 7170) is arranged between the second plurality of connecting wires (2132, 3132, 4132) and the interconnector (2140, 3140, 4140, 5141, 7141),
wherein the buffer strip (2700, 3700, 4170, 5170, 7170) is configured for reducing a pressure exerted by the interconnector (2140, 3140, 4140, 5141, 7141) on the connecting wires (2132, 3132, 4132) of the second plurality of connecting wires (2132, 3132, 4132) during formation of the solar cell module (2000, 3000, 4000, 5000, 7000).

2. Solar cell module (2000, 3000, 4000, 7000) according to claim 1,
wherein a first Young's modulus of the buffer strip (2700, 3700, 4170, 5170, 7170) is lower than a second Young's modulus of the connecting wires (2132) of the second plurality of connecting wires (2132).

3. Solar cell module (2000) according to claim 1 or 2,
wherein the first Young's modulus is less than 80 percent, in particular less than 50 percent, more particularly less than 30 percent, of the second Young's modulus.

4. Solar cell module (2000) according to any one of claims 1 to 3,
wherein the first solar cell (2111) is arranged between the contact portions (2151) and the bending portions (2152).

5. Solar cell module (4000) according to any one of claims 1 to 3,
wherein the contact portions (4151) are arranged between the first solar cell (4111) and the bending portions (4152).

6. Solar cell module (2000) according to any one of the preceding claims, further comprising
an insulating layer for electrically insulating the interconnector (2140) from the connecting wires (2132) of the second plurality of connecting wires (2132).

7. Solar cell module (2000) according to claim 6,
wherein the insulating layer comprises a coating of the interconnector (2140).

8. Solar cell module (2000, 3000, 4000) according to any one of the preceding claims,
wherein the interconnector (2140, 3140, 4140) is arranged at a side of the bended portions (2152, 3152, 4152) facing the contact portions (2151, 3151).

9. Solar cell module (7000) according to any one of claims 1 to 7,
wherein the interconnector (7141) is arranged at a side of the bended portions (7152) opposite to the contact portions.

10. Solar cell module (2000) according to any one of the preceding claims, further comprising
a first encapsulation layer (2801) and a second encapsulation layer (2802),
wherein the first encapsulation layer (2801) is made of a first encapsulation material, and
wherein the buffer strip (2700) is made of the first encapsulation material.

11. Solar cell module (5000) according to any one of the preceding claims, comprising
a first solar cell unit (5010) and a second solar cell unit (5020),
wherein the first solar cell unit (5010) and the second solar cell unit (5020) are electrically connected in parallel,
wherein the first solar cell unit (5010) comprises a solar cell subunit (5011),
wherein the second solar cell unit (5020) comprises a solar cell subunit,
wherein the first solar cell (5111) is part of the first solar cell subunit (5011).

12. Solar cell module (4000, 5000) according to any one of the preceding claims,
wherein the first solar cell is an interdigitated back contact (IBC) solar cell.

13. Solar cell module (5000) according to any one of the preceding claims,
wherein a distance between solar cells of the solar cell module (5000) arranged in a row is essentially equal for solar cells arranged in the row.

14. Solar cell module (5000) according to any one of the preceding claims,
wherein a distance between solar cells of the solar cell module (5000) arranged in a column is essentially equal for solar cells arranged in the column.

15. Solar cell module (5000) according to any one of the claims 11 to 14,
wherein at least the first solar cell unit (5010) comprises a first bridging element (5081) electrically connected in parallel to the solar cell subunit (5011).
